(19) **Europäisches Patentamt / European Patent Office / Office européen des brevets**

(11) **EP 3 000 931 B1**

(12) **EUROPEAN PATENT SPECIFICATION**

(45) Date of publication and mention
of the grant of the patent:
**28.02.2018 Bulletin 2018/09**

(51) Int Cl.:
**D06M 13/513** (2006.01)

(21) Application number: **15179230.6**

(22) Date of filing: **31.07.2015**

(54) **HEAT INSULATION SHEET AND METHOD OF PRODUCING THE SAME**

WÄRMEDÄMMPLATTE UND VERFAHREN ZUR HERSTELLUNG DAVON

FEUILLE D'ISOLATION THERMIQUE ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.08.2014 JP 2014171735**
 **28.05.2015 JP 2015108249**

(43) Date of publication of application:
**30.03.2016 Bulletin 2016/13**

(73) Proprietor: **Panasonic Intellectual Property Management Co., Ltd.**
**Osaka-shi, Osaka 540-6207 (JP)**

(72) Inventors:
 • **OIKAWA, Kazuma**
 **Osaka, 540-6207 (JP)**
 • **TOYOTA, Kei**
 **Osaka, 540-6207 (JP)**
 • **SAKATANI, Shigeaki**
 **Osaka, 540-6207 (JP)**

 • **MORITA, Masanori**
 **Osaka, 540-6207 (JP)**
 • **KONDO, Kenji**
 **Osaka, 540-6207 (JP)**
 • **KOHMYOHJI, Daido**
 **Osaka, 540-6207 (JP)**

(74) Representative: **Vigand, Philippe et al**
**Novagraaf International SA**
**Chemin de l'Echo 3**
**1213 Onex - Genève (CH)**

(56) References cited:
**DE-A1- 4 002 287      JP-A- 2011 136 859**
**US-A1- 2002 032 272**

 • **STEFAN BRZEZINSKI ET AL: "Applying the sol-gel method to the deposition of nanocoats on textiles to improve their abrasion resistance", JOURNAL OF APPLIED POLYMER SCIENCE, vol. 125, no. 4, 1 February 2012 (2012-02-01), pages 3058-3067, XP055026343, ISSN: 0021-8995, DOI: 10.1002/app.36353**

**Description**

1. Technical Field

The technical field relates to a heat insulation sheet and a method of producing the same.

2. Description of Related Art

An aerogel in a broad sense is a gel produced by drying an appropriate gel in a sense that it is a "gel in which the air is present as a dispersion medium." In this case, such an aerogel in a broad sense includes an aerogel in a narrow sense, xerogel, and also, cryogel.

Nomenclature for the gel in the narrow sense adopts different names depending on a difference in drying methods; a gel produced by use of a supercritical drying method is called as aerogel, a gel produced by drying under ordinary pressure is called as xerogel, and a gel produced by lyophilization is called as cryogel. The reason why there are some names in the narrow sense based on the difference in drying methods is because it is considered in the art that the most important step in production steps for an aerogel is in a drying method for removing a solvent from the gel.

The silica aerogel that was made of silicate particles and that was first synthesized by S. S. Kister in 1931 (Nature, 127, 741 (1931)) had a pore diameter equal to or smaller than a mean free path (68 nm) of molecules constituting the air, although the silica aerogel did not contain a foaming gas with low heat conductivity, such as $CO_2$ or cyclopentane. Therefore, it has been known that the silica aerogel exhibits excellent heat insulation effects.

A silica aerogel is different from foamed urethane (PU) or Styrofoam (EPS), which is a general-purpose heat insulation material, or a vacuum heat insulation material (VIP). Almost no changes are found in its heat insulation performance of the silica aerogel over time, and a silica aerogel has heat resistance at 400°C or higher. This has attracted an attention as a next-generation heat insulation material.

As to PU or EPS that is produced based on foaming with a gas with low heat conductivity, not only the heat insulation performance is deteriorated as the gas is released therefrom over time, but also there is a problem of poor heat resistance. Additionally, VIP has a problem of time degradation in which a minute amount of air molecules penetrate thereinto, over time, from a portion to which a core material is bonded based on heat-sealing when the core material is vacuum-encapsulated therein, thereby causing a reduction in the vacuum degree, as well as a problem in which the heat resistance is as low as about 100°C, although VIP has excellent heat insulation performance with several milliwatts per meter-kelvin.

A silica aerogel is superior to existing heat insulation materials in terms of time degradation or heat resistance, and has a superior heat conductivity around 15 m W/mK. However, in a silica aerogel, a network structure like beads, in which silica particles on a scale of several ten nanometers are connected with one another by point contact is formed. Therefore, its mechanical strength is not very sufficient. Hence, in order to overcome the fragility of a silica aerogel, studies have been made on improvements in its strength based on combination with fibers or unwoven fabrics, or resins or the like.

For example, a method in which an aerogel and a crystalline polymer are mixed in a dry state, and the resulting mixture is subjected to a heat treatment to prepare an aerogel coated with the polymer has been known (JP-A-2009-73731). In this case, since the polymer is added to the aerogel where the volume ratio of the polymer and the aerogel is 1:1 or 1:2, the mechanical strength is improved. However, the molten polymer penetrates into nanosized voids in the aerogel, and resinification partially occurs in the aerogel. This has caused a problem of high heat conductivity.

In addition, a method in which fibers are impregnated with a material solution, thereby producing a heat insulation material, for the purpose of reinforcement of the xerogel skeleton, has been reported (JP-T-10-504793). However, in this case, there has been a problem of detachment or loss of silica xerogel particles from the surface.

SUMMARY

In a composite material of fibers and a silica xerogel, there has been no effective method for preventing detachment or loss of gel fine particles of silica xerogel. Therefore, this has hampered expansion of the composite material to the field of electronic devices that are intolerant of deterioration of heat insulation performance or incorporation of particles. Consequently, although a silica xerogel is an excellent heat insulation material, its application was difficult.

An object is to provide a heat insulation sheet including as a substrate a silica aerogel with low heat conductivity and high mechanical strength, as well as a method of producing the same.

In order to achieve the above object, a heat insulation sheet, including: a silica xerogel; and an unwoven fabric, wherein the silica xerogel and the unwoven fabric are chemically cross-linked to one another through a silane coupling agent having a reactive organic functional group is used.

Furthermore, a method of producing a heat insulation sheet, including: providing as a material a high molar ratio silicate aqueous solution having a particle size of 1 to 10 nm, which is a medium size between water glass and colloidal silica, and adding an acid to the high molar ratio silicate aqueous solution to prepare a sol; or providing a water glass as a material, removing sodium from the water glass by ion exchange, and then, adding a base thereto to prepare a sol solution; impregnating a fabric with the sol solution; conducting a polymerization reaction based on dehydration condensation at 50°C to 100°C to obtain a hydrogel; hydrophobizing a surface of the hydrogel with a silane coupling agent having a reactive organic functional group, the silane coupling agent represented by $Y_nSi(OR)_{4-n}$; drying the hydrophobized hydrogel at 80°C or lower; and heating the dried hydrogel to 100°C or higher to cause Y, which is the reactive organic functional group, to undergo a ring opening polymerization, thereby allowing a silica xerogel and the unwoven fabric to bind to each other, wherein, in the silane coupling agent represented by $Y_nSi(OR)_{4-n}$, Y, which corresponds to the reactive organic functional group, is any of a glycidoxypropyl group, a 3,4-epoxycyclohexylethyl group, a styryl group, an acrylate group, a methyl methacrylate group, a vinyl group and a derivative thereof, a thiol propyl group, and an aminopropyl group, R is any of a methyl group, an ethyl group and a propyl group, and n is 1 to 3 is used.

In the heat insulation sheet, detachment or loss of silica xerogel from fibers of unwoven fabrics will not occur even in long-term use. Therefore, the heat insulation sheet can be applied to electronic devices that are intolerant of deterioration of heat insulation performance or incorporation of particles.

The above heat insulation sheet can be produced by the method of producing a heat insulation sheet.

BRIEF DESCRIPTION OF THE DRAWINGS

FIG. 1 is a diagram that illustrates cross-linking of a silica xerogel and an unwoven fabric fiber through a silane coupling agent having a reactive organic functional group in an embodiment.

FIG. 2 is a diagram that illustrates the process according to an embodiment.

FIG. 3 is a diagram that illustrates a chemical bonding state in a hydrophobization step in an embodiment.

FIG. 4 is a diagram that illustrates cross-linking of a silica xerogel and an unwoven fabric fiber through a silane coupling agent having a reactive organic functional group.

FIG. 5 is diagram that illustrates cross-linking of silica xerogels to one another through a silane coupling agent in an embodiment.

FIG. 6 is a diagram that illustrates cross-linking of a silica xerogel and an unwoven fabric fiber through a silane coupling agent having a reactive organic functional group in an embodiment.

DESCRIPTION OF EMBODIMENTS

One embodiment will be described below.

(Silica xerogel 101)

A silica xerogel 101 in an embodiment includes a dehydration condensate that is produced by adding a base to a silicate aqueous solution obtained by providing, as a material, water glass (a sodium silicate aqueous solution) and by subjecting it to sodium removal based on ion exchange with an ion-exchange resin or by electrodialysis.

Alternatively, the silica xerogel 101 includes a dehydration condensate that is produced by adding an acid to a high molar ratio silicate aqueous solution having a particle diameter that is a medium size (1 to 10 nm) between water glass and colloidal silica, as a material.

<Mean pore diameter>

The silica xerogel 101 produced by the production method in the embodiment has a mean pore diameter of 10 to 55 nm and a pore volume of 3.0 to 10 cc/g.

The mean pore diameter is preferably 10 to 55 nm.

If the mean pore diameter is smaller than 10 nm, a bulk density of the xerogel becomes large, and, consequently, the proportion of heat conductive components of the solid (silica particles) is increased. Therefore, the value of the heat conductivity becomes large.

If the mean pore diameter is larger than 55 nm, a bulk density of the xerogel becomes small, and the amount of components for the heat conductivity of the solid is reduced. However, since the proportion of voids in the xerogel is increased, influences of the convection of the air (nitrogen molecules) will be significant, and the value of the heat conductivity becomes large.

<Pore volume>

The pore volume is preferably 2.5 to 10 cc/g.

If the pore volume is smaller than 2.5 cc/g, a proportion of the solid heat conductive components will be increased in the same manner as the case where the mean pore diameter is smaller than 10 nm. Therefore, the value of the heat conductivity becomes large.

If the pore volume is larger than 10 cc/g, an amount of components for the heat conductivity of the solid will be reduced. However, since a proportion of voids in the xerogel will be increased, influences of the convection will be significant. Consequently, the value of the heat conductivity becomes large.

<Summary>

When the mean pore diameter and the pore volume of the silica xerogel 101 are within the above-described ranges, the silica xerogel 101 exhibits excellent heat insulation properties, and therefore, is suitable as a heat insulation material.

As to control of the mean pore diameter and the pore volume of the silica xerogel 101, they can easily be controlled by adjusting a silicate concentration of water glass, which is a material, and a type (a pH, dispersion solvent, particle diameter, shape of particles, and particle concentration) and an amount of a basic colloidal silica used for the solation, conditions (a temperature and time) for gelation of the sol, curing conditions (a temperature and time), etc.

(Heat insulation sheet)

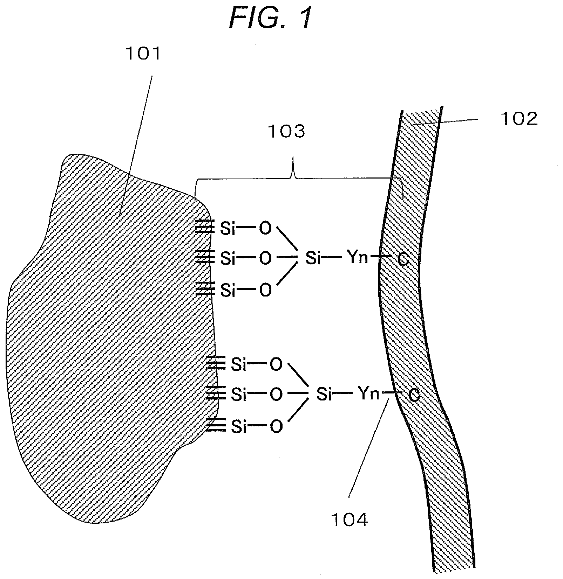

A heat insulation sheet according to the embodiment is an unwoven fabric that includes the above-described silica xerogel 101, which has a heat conductivity of 0.010 to 0.020 W/mK. Its features are shown in FIG. 1. FIG. 1 is a diagram that shows the chemical bonding. In the heat insulation sheet, the silica xerogel 101 and an unwoven fabric fiber 102 are chemically cross-linked to each other through a silane coupling agent 103 having a reactive organic functional group 104. The heat insulation sheet is a heat insulation sheet with a heat conductivity of 0.015 to 0.025 W/mK.

<Unwoven fabric fiber 102>

The unwoven fabric fiber 102 may be either an inorganic fiber or an organic fiber. However, it is preferable to determine which of the inorganic and organic fibers is used therefor, depending on the purpose. For example, for fields that require heat resistance or flame retardance besides heat insulation properties (e.g., automobiles or aircrafts), an inorganic fiber, which has excellent heat resistance or flame retardance, is preferably selected. An organic fiber is preferably used for fields that do not require heat resistance or flame retardance (e.g., mobiles such as smart phones, tablets and notebook PCs, and household electrical appliances).

For the inorganic fiber, glass wool, rock wool, and an alumina fiber are preferable in terms of heat insulation properties, heat resistance, flame retardance and dimension stability. A carbon fiber is not preferable since it has high heat conductivity and poor heat insulation properties. A fiber diameter of glass wool, rock wool or an alumina fiber may be 1 to 20 um, and its fiber length may be 3 to 25 mm. A fiber within such ranges has low heat conductivity, and therefore, is preferable. Additionally, a fiber within the ranges of fiber diameter and fiber length will exhibit a heat conductivity of the unwoven fabric alone within a range of 0.03 to 0.05 W/mK.

If the fiber diameter is larger than 20 um or if the fiber length is larger than 25 mm, the solid heat conductive components in the inorganic fiber will be increased, and the heat conductivity becomes larger than 0.05 W/mK. Consequently, even when the silica xerogel 101 is contained in fibers, the heat conductivity of the finally-prepared heat insulation material will exceed 0.025 W/mK, and therefore, this is not preferable.

In a case of fibers with a fiber diameter less than 1 mm and with a fiber length less than 3 mm, entanglement of the fibers will significantly be reduced, and a form of sheet cannot be maintained. Therefore, such fibers are not preferable.

For the organic fiber, polyethylene terephthalate (PET), polyvinyl chloride (PVC), and polytetrafluoroethylene (PTFE) are preferable in view of heat insulation properties and chemical stability. Organic fibers such as polypropylene, polyethylene and cellulose do not cause any problem in terms of heat insulation properties as far as their fiber diameter and fiber length are adjusted to appropriate ranges. However, they are not preferable because they lack sufficient chemical stability (acid resistance in this case). As described below, production steps for a heat insulation sheet containing a silica xerogel 101 include a step of immersing an unwove fabric in hydrochloric acid, and the unwoven fabric requires acid resistance. However, organic fibers such as polypropylene, polyethylene, and cellulose are not suitable because they do not have acid resistance.

(Method of producing a heat insulation sheet containing a silica xerogel 101)

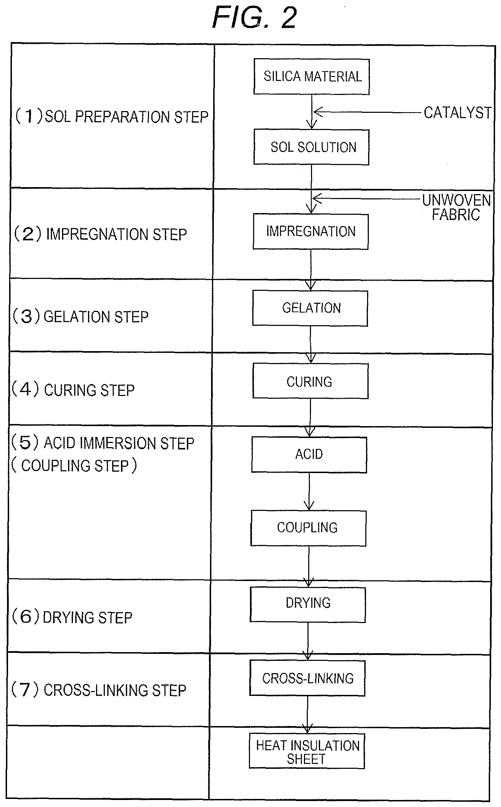

An overview of a method of producing a heat insulation sheet containing a silica xerogel 101 will be described by use of a flow diagram of FIG. 2. The method of producing a heat insulation sheet includes seven steps of (1) to (7) in FIG. 2. The seven steps are as follows:

(1) a sol preparation step in which a catalyst is added to water glass or high molar ratio sodium silicate as a material to prepare a sol;
(2) a step in which an unwoven fabric is impregnated with the sol;
(3) a step in which the sol is allowed to gelate inside the unwoven fabric;
(4) a curing step in which a skeleton of silica is reinforced;
(5) a step in which the gel sheet is immersed in an acidic aqueous solution (a hydrophobization step in which the gel sheet is reacted with the silane coupling agent 103 having the reactive organic functional group 104);
(6) a step in which a solvent is removed by drying; and
(7) a polymerization step in which the reactive organic functional group 104 and the unwoven fabric fiber 102 are chemically bonded to each other by heat polymerization.

Each of the steps will be described below.

(1) Sol preparation step

For the sol preparation step, there is a case where water glass is used as a material, and a case where a high molar ratio silicate aqueous solution is used as a material.
In a case where water glass is used, sodium in water glass is removed with an ion-exchange resin or by electrodialysis, is made acidic, and formed into a sol. Then, a base as a catalyst is added to the sol, and is polycondensed to form a hydrogel.
In a case where a high molar ratio silicate aqueous solution is used, an acid as a catalyst is added to the high molar ratio silicate aqueous solution, and is polycondensed to form a hydrogel.

<Water glass>

Water glass is a sodium silicate aqueous solution or a silicate soda aqueous solution, and is a liquid that is produced by dissolving $SiO_2$ (silica) and $Na_2O$ (sodium oxide) in $H_2O$ at various ratios. The molecular formula of water glass is expressed as $Na_2O \cdot nSiO2 \cdot mH_2O$, and n is called a molar ratio, which represents a mixing ratio of $Na_2O$ and $SiO_2$. Types of water glass prescribed in the Japanese Industrial Standards (JIS K1408) include Nos. 1, 2 and 3, and the above-mentioned molar ratios of these types are described as 2, 2.5 and 3, respectively. Since water glass used as a material in the invention is diluted with pure water for use, there are not any preferable molar ratios in particular, and water glass with a molar ratio of 2 to 3 that is generally used can be used in the invention.

<High molar silicate aqueous solution>

A high molar ratio silicate aqueous solution is a material that is obtained by removing sodium, which is unnecessary for formation of a hydrogel, from water glass, followed by stabilization at sides of the base. The high molar ratio silicate aqueous solution is neither water glass nor colloidal silica. In this case, colloidal silica is a colloid of $SiO_2$ or a hydrate thereof, and generally refers to those that generally have a particle diameter of 10 to 300 nm and that do not have a certain structure.
Water glass is an aqueous solution with a high concentration of sodium silicate, and refers to a starch syrup-like liquid that is obtained by dissolving sodium silicate in water, followed by heating. On the other hand, a high molar ratio silicate aqueous solution refers to a solution that is obtained by removing sodium from such water glass and by further adjusting the silica concentration to 8% or higher. One feature of such a high molar ratio silicate aqueous solution is that a particle diameter of the sol is a medium size (1 to 10 nm) between water glass and colloidal silica.
A diameter of silicate particles in the high molar ratio silicate aqueous solution is preferably 1 to 10 nm. If the particle diameter is smaller than 1 nm, the particle diameter is too small to form an origin for the nucleus growth, and there may be a case where an effect to shorten the curing time cannot be obtained. If the particle diameter exceeds 10 nm, not only activities of silicate particles alone are lowered, but also a homogeneous network of silica particles cannot be formed. Therefore, there may be a case where the strength of the hydrogel is insufficient.
The high molar ratio silicate aqueous solution used in the embodiment preferably has a silicate concentration of 13% to 20%.

When a silicate concentration of the high molar ratio silicate aqueous solution is less than 13%, it is required that a larger amount of the high molar ratio silicate aqueous solution be added thereto for adjusting the PH of water glass to a desired value. Therefore, the number of colloidal silica that is supposed to be an origin for silica particle growth will be reduced, and there may be a case where formation of the silica network does not effectively proceed.

If a silicate concentration of the high molar ratio silicate aqueous solution exceeds 20%, there is a problem in which a pot life of the material itself becomes short. In other words, even when the material is allowed to stand at ordinary temperature, the viscosity increases, and the material will gelate.

(2) Impregnation step

The sol solution prepared in Step (1) is poured into an unwoven fabric with a thickness of 0.05 to 1.0 mm at a quantity 6.5 to 10 times as large as the weight of the unwoven fabric, and the unwoven fabric is impregnated with the sol solution with a hand roller. In this case, a viscosity of the sol solution is preferably 1 to 10 mPa·s (at 20°C), and is more preferably 1 to 5 mPa·s in order to increase the impregnation rate.

In addition, in a case of inorganic fibers, glass wool or rock wool can be used for the unwoven fabric. In a case of organic fibers, polyethylene terephthalate (PET), polyvinyl chloride (PVC), or polytetrafluoroethylene (PTFE) can be used.

However, in order to improve the wettability, the unwoven fabric fiber 102 may be subjected to UV ozone-based cleaning or atmospheric pressure plasma-based cleaning, or a surfactant may be contained in the unwoven fabric, prior to impregnation with the sol solution.

In addition, when the unwoven fabric is impregnated with the sol solution, it is desirable that the unwoven fabric is impregnated with the sol solution under room temperature within 5 minutes after the sol is prepared. When 5 minutes or more passed, the viscosity of the sol solution is increased to 10 mPas or higher, and the impregnation rate suddenly becomes low.

(3) Gelation step

<Gelation temperature>

After Step (2), the sol is allowed to gelate. The gelation temperature for the sol is preferably 20°C to 90°C.

When the gelation temperature is less than 20°C, required heat is not transmitted to silicate monomers that are active species for the reaction. Consequently, the growth of silica particles is not promoted. As a consequence, it takes a long time to allow gelation of the sol to proceed sufficiently. Furthermore, the strength of the produced gel (hydrogel) is low. Therefore, the gel may be shrunk significantly during drying, and a hydrogel with desired strength may not be obtained.

In addition, the growth of silica particles is excessively promoted when the gelation temperature exceeds 90°C. As a result, volatilization of water rapidly occurs, and a phenomenon in which water and the hydrogel separate will be observed. This leads to a reduction in the volume of the resulting hydrogel, and there is a case where the desirable silica xerogel 101 cannot be obtained.

<Gelation time>

In addition, the gelation time varies with the gelation temperature or a curing time after the gelation described below. However, a sum of the gelation time and the curing time described below is preferably 0.5 to 12 hours, and more preferably 1 to 6 hours in order to satisfy both of performance (heat conductivity) and production tact.

If the gelation time is shorter than 0.5 hour, a network of silica particles is not sufficiently reinforced, and therefore, the gel is shrunk and the bulk density is increased during drying.

If the gelation time is longer than 12 hours, reinforcement of the silica network is sufficiently proceeded. However, if more time is spent for curing, not only productivity is impaired, but also shrinkage of the gel occurs, and the bulk density is increased. Consequently, there is a problem of increased heat conductivity.

When the gelation time is 1 to 6 hours, based on gelation and curing, the network of silica particles can sufficiently be reinforced while sufficient productivity is secured.

<Summary>

By conducting gelation and curing in this way, the strength or rigidity of the wall of the hydrogel is improved, and a hydrogel that hardly shrinks during drying can be obtained.

(4) Curing step

The curing step is a step of forming the skeleton of the silica into a hydrogel with a reinforced skeleton after gelation.

<Curing temperature>

The curing temperature is preferably 50°C to 100°C.
If the curing temperature is lower than 50°C, the dehydration condensation reaction becomes relatively slow, and therefore, it becomes difficult to sufficiently reinforce the silica network within a target tact time in view of productivity.
If the curing temperature is higher than 100°C, the water in the gel is excessively evaporated. Therefore, shrinkage or dryness of the gel is caused, and the heat conductivity will be increased.

<Curing time>

The curing time is preferably 0.1 to 12 hours, and more preferably 0.5 to 6 hours in order to satisfy both of performance (heat conductivity) and production tact.
If the curing time is shorter than 0.1 hour, the network of silica particles is not sufficiently reinforced. Consequently, the gel will be shrunk and the bulk density will be increased during drying.
If the curing time is longer than 12 hours, reinforcement of the silica network is sufficiently proceeded. However, if more time is spent for curing, not only the productivity is impaired, but also shrinkage of the gel occurs and the bulk density is increased. Consequently, there will be a problem that the heat conductivity is increased.
When curing is carried out where the curing time is within a range of 0.5 to 6 hours, the network of silica particles can sufficiently be reinforced while securing the productivity.

<Control>

To increase the pore volume or the mean pore diameter of the xerogel, the gelation temperature or the curing temperature are preferably elevated within the above-mentioned ranges, or a sum of the gelation time and the curing time is preferably prolonged within the above-described range.
In addition, to reduce the pore volume or mean pore diameter of the xerogel, the gelation temperature or the curing temperature are preferably lowered within the above-described ranges, or a sum of the gelation time and the curing time is preferably shortened within the above-described range.

(5) Acidic aqueous solution immersion step

The cured hydrogel (gel containing water) is reacted with a silylating agent to conduct hydrophobization, and is formed into a surface-modified gel. Therefore, the cured sheet is immersed in an acidic aqueous solution. The acidic aqueous solution is not particularly limited, and a hydrochloric acid aqueous solution, sulfuric acid aqueous solution, acetic acid aqueous solution, formic acid aqueous solution and the like are appropriately used.

<pH of the solution>

The pH of the acidic aqueous solution is preferably 4.5 or lower.
If the pH is higher than 4.5, a hydrolysis reaction of an alkoxysilane becomes excessively slow.
If the pH is 4.5 or lower, the hydrolysis reaction occurs without any problem under conditions of ordinary pressure and ordinary temperature.

<Silylating agent>

As the silylating agent for the hydrophobization treatment in the embodiment, the silane coupling agent 103 can be used. The silylating agent is not limited, but an alkoxysilane represented by $YnSi(OR)_{4-n}$, having at least one type of the reactive organic functional group 104 can be used as a starting material. By use of this silane coupling agent 103, a dehydration condensation with silanol groups on the surface of the hydrogel is carried out under acidic conditions.
In this case, for the silane coupling agent 103 represented by $YnSi(OR)_{4-n}$, any of a glycidoxypropyl group, a 3,4-epoxycyclohexylethyl group, a styryl group, an acrylate group, a methyl methacrylate group, a vinyl group and a derivative thereof, a thiol propyl group, and an aminopropyl group can be selected as Y that corresponds to the reactive organic functional group 104. A reaction induction method, such as based on a photoreaction, a heat reaction or their combination, can appropriately be selected.

In addition, two or more types of these functional groups may be combined. In particular, a thiol propyl group or aminopropyl group can favorably be used in combination with a glycidoxypropyl group, because they can polymerize a glycidoxypropyl group.

As a glycidoxypropyl group, 3-glycidoxypropylmethyldimethoxysilane, 3-glycidoxypropylmethyltrimethoxysilane, 3-glycidoxypropylmethyldiethoxysilane, 3-glycidoxypropylmethyltrimethoxysilane, and 2-(3,4-epoxycyclohexyl)ethyltrimethoxysilane can be used.

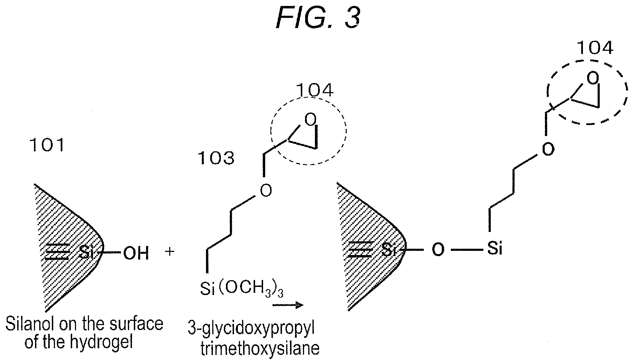

For example, by use of 3-glylcidoxypropyltrimethoxysilane, dehydration condensation with silanol groups on the surface of the hydrogel can be conducted under acidic conditions to carry out hydrophobization. Changes of the chemical bonding state in this case are shown in FIG. 3.

R can be a $C_1$-$C_3$ alkyl group, although it is not limited thereto, and, specifically, methoxysilane, ethoxysilane, propoxysilane and the like can be mentioned. Among them, methoxysilane and ethoxysilane are preferable because hydrolysis is easily caused, and the reaction can easily be controlled.

<Charging amount of silylating agent>

For a charging amount of the silylating agent, 100% to 800% is preferable, and 100% to 300% is more preferable to a pore volume of the skeleton-reinforced hydrogel.

If the amount of the silylating agent is less than 100% of the pore volume, it becomes difficult to physically immerse the hydrogel in the silylating agent. As a result, there is a case where silanol (Si-OH) groups that exist on the surface and the inside of the skeleton-reinforced hydrogel remain unreacted.

In that case, the silanol groups come into physical contact with one another due to a capillary force of the solvent during drying, thereby causing a dehydration condensation reaction, and this may lead to shrinkage and high density of the gel.

<Proportion of silylating agent>

If the amount of the silylating agent is larger than 800% of the pore volume, there may be a case where the silylating agent exists at a more excessive amount than a minimum amount of the silylating agent that should be reacted with silanol groups. In that case, the economic efficiency and the productivity will be impaired.

When the charging amount of the silylating agent is 100% to 300% of the pore volume, the hydrogel can physically be immersed in the silylating agent. Therefore, the silylation reaction proceeds without any problem, and a large amount of the silylating agent is not consumed. As a result, high production costs due to an increase in the size of the reaction bath and an increase in the amount of silylating agent used therein will be avoided.

In addition, the charging amount of the silylating agent is based on the pore volume of the skeleton-reinforced hydrogel. For example, when the charging amount of the silylating agent is 150% of the pore volume, this means that an amount of the silylating agent 1.5 times as large as the pore volume of the skeleton-reinforced hydrogel is added thereto.

<Pore volume of the skeleton-reinforced hydrogel>

The pore volume of the skeleton-reinforced hydrogel is a value obtained by subtracting a volume of $SiO_2$ per unit weight from a volume of the high molar ratio silicate aqueous solution per unit weight, and is calculated based on the following formulas.

```
A pore volume of the skeleton-reinforced hydrogel (volume of
water in the gel) = a volume of the high molar ratio silicate aqueous
solution - a volume of SiO₂ ··· (Formula 1)

A volume of the high molar ratio silicate aqueous solution =
a weight x of the high molar ratio silicate aqueous solution [g] /
a density of the high molar ratio silicate aqueous solution (1.1)
[cm³/g] ··· (Formula 2)
```

$$A \text{ volume of } SiO_2 = (\text{the weight } x \text{ of the high molar ratio silicate}$$
$$\text{aqueous solution [g]} \times \text{a silicate concentration}) / \text{a density of } SiO_2$$
$$(2.2) \ [cm^3/g] \ \cdots \ (Formula \ 3)$$

<Other silylating agents>

Besides the silane coupling agent 103 having a reactive organic functional group 104, one or more types of siloxane-based solvents represented by $R_3SiO (SiR_2O)_nSiR_3$ (where n is 0 to 2) may be combined as silylating agents. HMDSO (hexamethyldisiloxane), octamethyltrisiloxane, and decamethyl tetrasiloxane are preferably used.

In addition, it is a silane represented by $R^1{}_3SiCl$ or $R^1{}_nSi (OR^2)_{4-n}$ (wherein $R^1$ and $R^2$ are each independently a C1-C6 linear alkyl, cyclic alkyl or phenyl), and hexamethyldisilazane (hereinafter, HMDS) is also suitable.

Trimethylchlorosilane (hereinafter, TMCS) is preferably used for $R^1{}_3SiCl$, and methyltrimethoxysilane (MTMS) is preferably used for $R^1{}_nSi(OR^2)_{4-n}$.

<Temperature for the hydrophobization reaction>

The hydrophobization reaction is conducted in a solvent, as needed, and is performed generally at 20°C to 100°C.

If the reaction temperature is lower than 20°C, diffusion of the silylating agent is insufficient, and there may be a case where hydrophobization does not proceed sufficiently.

If the reaction temperature exceeds 100°C, the silylating agent itself is evaporated, and there may be a case where the silylating agent required in the reaction is not supplied to the outside and the inside of the skeleton-reinforced hydrogel.

<Solvent>

As for the solvent used herein, alcohols such as methanol, ethanol, 2-propanol, tert-butanol and ethylene glycol; ketones such as acetone and methylethylketone; and linear aliphatic hydrocarbons such as pentane, hexane and heptane are preferable.

The skeleton-reinforced hydrogel is solid and hydrophilic. To the contrary, the silylating agent is liquid and hydrophobic. Therefore, they are not mixed with each other. Furthermore, because of a solid-liquid heterogeneous system reaction, alcohols or ketones, which are amphiphilic solvents, are preferably used in order to efficiently reacting the silylating agent, which is an active species, with the skeleton-reinforced hydrogel, and alcohols are more preferable.

(6) Drying step

As a drying technique used in the drying step for volatilizing a liquid solvent in the surface-modified gel obtained in the preceding step, either a supercritical drying method or non-supercritical drying method (an ordinary pressure drying method or freeze-drying method) can be used as a known drying method, and there is no particular limitation thereto.

However, an ordinary pressure drying method is preferably used as a non-supercritical drying method in terms of mass productivity, safety and economic efficiency.

The drying temperature depends on a type of the reactive organic functional group 104 of the silane coupling agent 103. However, the drying temperature is preferably 80°C or lower.

If drying is carried out at a temperature higher than 80°C, volatilization of the solvent and the ring-opening polymerization of reactive organic functional groups 104 simultaneously occur, and there may be a case where cross-linking of the silica xerogel 101 and the unwoven fabric fiber 102 does not sufficiently proceed.

When the temperature is 80°C or lower, the pressure during drying is preferably equal to or lower than the ordinary pressure in order to carry out drying in a short time.

(7) Cross-linking step

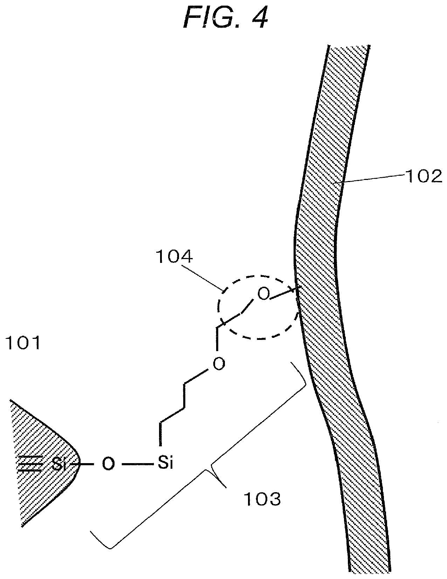

The cross-linking step is a step in which reactive organic functional groups 104 of the surface-modified gel after drying are subjected to ring-opening polymerization, thereby forming covalent bonds between the silica xerogel 101 and the unwoven fabric fiber 102. In the cross-linking step, the cross-linking reaction can be promoted by heating or light irradiation. A chemical bonding state in this case is shown in FIG. 4.

The silica xerogel 101 and the unwoven fabric fiber 102 are bonded to each other through the silane coupling agent 103. Through the reactive organic functional group 104 of the silane coupling agent 103, the silane coupling agent 103 is linked to the unwoven fabric fiber 102. The silica xerogel 101 is tightly attached to the unwoven fabric fiber 102, and loss of the powder from the silica xerogel 101 can be prevented.

The heating temperature varies with the material of the unwoven fabric fiber 102. In a case where the unwoven fabric fiber 102 is made of inorganic fibers (glass wool, rock wool, or the like) having high heat resistance, the heating temperature is preferably 100°C to 200°C.

In a case of organic fibers (polyethylene terephthalate (PET), polyvinyl chloride (PVC), or the like), the heating temperature is preferably 100°C to 150°C in terms of the heat resistance.

In addition, the unwoven fabric sheet may be pressed, as needed, and then, the cross-linking reaction may be carried out within the above-described temperature range. In that case, the pressure range is preferably 1 to 20 MPa.

If the pressure is lower than 1 MPa, a distance between the reactive organic functional group 104 and the unwoven fabric fiber 102 is excessively long, and therefore, there may be a case where the reaction does not sufficiently proceed.

If the pressure is higher than 20 MPa, the silica xerogel 101 may physically be destroyed. Consequently, even when the cross-linking reaction is carried out, the silica xerogel 101 may be detached from or dropped out of the unwoven fabric fiber 102.

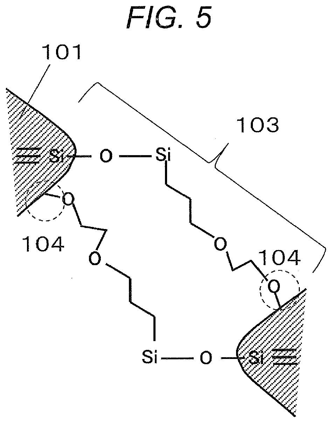

In addition, the reactive organic functional group 104 also reacts with the silica xerogel 101 in that case. A chemical bond in that case is shown in FIG. 5. The silica xerogels 101 are bonded to each other through the silane coupling agent 103. The silica xerogels 101 are also bonded to each other, and loss of powder from the silica xerogels 101 is prevented.

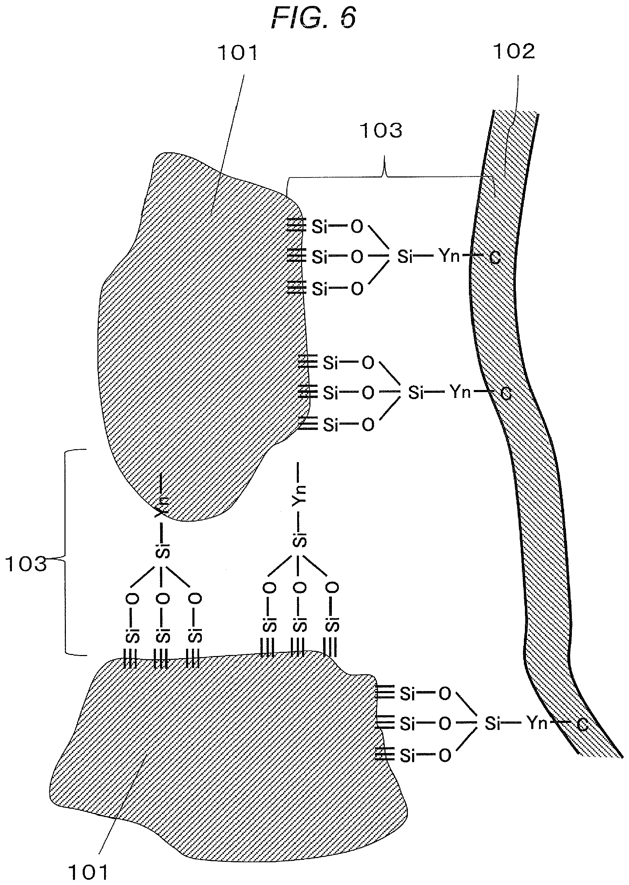

When the state of FIG. 1 is combined with the state of FIG. 5, FIG. 6 is obtained. In FIG. 6, the silica xerogels 101 and the unwoven fabric fiber 102 are integrated with each other, and thus, are bonded to each other.

The silica xerogels 101 and the unwoven fabric fiber 102 are bonded to each other so as to from a mesh-like structure, and thus, loss of powder from the silica xerogel 101 can be prevented.

(Effects)

As described above, when the production method different from conventional arts, in which a hydrophobization reaction of the silica xerogel 101 is carried out by use of the silane coupling agent 103 having the reactive organic functional group 104, and then, a covalent bond is formed between the unwoven fabric fiber 102 and the silica xerogel 101 based on ring-opening polymerization of the reactive organic functional groups 104, is used, a heat insulation sheet including, as a substrate, the silica xerogel 101 with high mechanical strength and low heat conductivity can be produced.

According to the heat insulation sheet, detachment or loss of the silica xerogel 101 from the unwoven fabric fiber 102 does not occur even in long-term use. Therefore, the heat insulation sheet can be applied to electronic devices that are intolerant of deterioration of heat insulation performance or incorporation of particles.

In this invention the unwoven fabric fiber 102 is used. But it is possible to use the woven fabric fiber instead of the unwoven fabric fiber.

Accordingly, by chemically bonding the silica xerogel 101 with low heat conductivity and the unwoven fabric 102 with each other through the silane coupling agent 103 having the reactive organic functional group 104, detachment or loss of the silica xerogel 101 is prevented, and a sheet with high mechanical strength and with excellent heat insulation properties is provided. The heat insulation material can favorably be used for purposes such as for household electrical appliances, automobile components, the field of buildings, and industrial facilities.

**Claims**

1.  A heat insulation sheet, comprising:

    a silica xerogel (101); and
    a unwoven fabric (102), wherein
    the silica xerogel and the unwoven fabric are chemically cross-linked to one another through a silane coupling agent (103) having a reactive organic functional group (104).

2.  The heat insulation sheet according to claim 1, wherein a plurality of silica particles of said silica xerogel are chemically cross-linked to one another through the silane coupling agent.

3.  The heat insulation sheet according to claim 1 or 2, wherein the silane coupling agent (103) is an alkoxysilane compound represented by $Y_nSi(OR)_{4-n}$ having at least one type of the reactive organic functional group Y (104).

**4.** The heat insulation sheet according to claim 3, wherein any one or more of $R_3SiO (SiR_2O)_nSiR_3$, $R_3SiCl$, and $R^1_nSi(OR^2)_{4-n}$ is further included as a silylating agent.

**5.** The heat insulation sheet according to claim 3, wherein Y is any one or more of a glycidoxypropyl group, a 3,4-epoxycyclohexylethyl group, a styryl group, an acrylate group, a methyl methacrylate group, a vinyl group and a derivative thereof, a thiol propyl group, and an aminopropyl group.

**6.** The heat insulation sheet according to claim 3, wherein R is any of a methyl group, an ethyl group and a propyl group.

**7.** A method of producing a heat insulation sheet, comprising:

providing as a material a high molar ratio silicate aqueous solution having a particle size of 1 to 10 nm, which is a medium size between water glass and colloidal silica, and adding an acid to the high molar ratio silicate aqueous solution to prepare a sol; or
providing a water glass as a material, removing sodium from the water glass by ion exchange, and then, adding a base thereto to prepare a sol solution;
impregnating a unwoven fabric with the sol solution;
conducting a polymerization reaction based on dehydration condensation at 50°C to 100°C to obtain a hydrogel;
hydrophobizing a surface of the hydrogel with a silane coupling agent having a reactive organic functional group, the silane coupling agent represented by $Y_nSi(OR)_{4-n}$;
drying the hydrophobized hydrogel; and
heating the dried hydrogel to 100°C or higher to cause Y, which is the reactive organic functional group, to undergo a ring opening polymerization, thereby allowing a silica xerogel and the fabric to bind to each other, wherein,
in the silane coupling agent represented by $Y_nSi(OR)_{4-n}$, Y, which corresponds to the reactive organic functional group, is any of a glycidoxypropyl group, a 3,4-epoxycyclohexylethyl group, a styryl group, an acrylate group, a methyl methacrylate group, a vinyl group and a derivative thereof, a thiol propyl group, and an aminopropyl group,
R is any of a methyl group, an ethyl group and a propyl group, and
n is 1 to 3.

**8.** The method of producing a heat insulation sheet according to claim 7, wherein Y, which corresponds to the reactive organic functional group, is a glycidoxypropyl group.

**9.** The method of producing a heat insulation sheet according to claim 7, wherein any one of

3-glycidoxypropylmethyldimethoxysilane,
3-glycidoxypropylmethyldiethoxysilane, and
2-(3,4-epoxycyclohexyl)ethyltrimethoxysilane

is used for $Y_nSi(OR)_{4-n}$ in the hydrophobizing step.

**10.** The method of producing a heat insulation sheet according to claim 7, wherein 3-glycidoxypropyltrimethoxysilane is used for $Y_nSi(OR)_{4-n}$ in the hydrophobizing step.

**Patentansprüche**

**1.** Wärmedämmplatte, die Folgendes umfasst:

ein Silica-Trockengel (101); und
einen Vliesstoff (102), wobei
das Silica-Trockengel und der Vliesstoff durch einen Silan-Haftvermittler (103), der eine reaktive organische funktionelle Gruppe (104) aufweist, chemisch miteinander vernetzt sind.

**2.** Wärmedämmplatte nach Anspruch 1, wobei mehrere Silica-Partikel des Silica-Trockengels durch den Silan-Haftvermittler chemisch miteinander vernetzt sind.

**3.** Wärmedämmplatte nach Anspruch 1 oder 2, wobei der Silan-Haftvermittler (103) eine Alkoxysilanverbindung ist, die durch $Y_nSi(OR)_{4-n}$ dargestellt ist, die mindestens einen Typ der reaktiven organischen funktionellen Gruppe Y (104) aufweist.

**4.** Wärmedämmplatte nach Anspruch 3, wobei eines oder mehrere von $R_3SiO(SiR_2O)_nSiR_3$, $R_3SiCl$ und $R^1_nSi(OR^2)_{4-n}$ ferner als ein Silylierungsmittel enthalten ist.

**5.** Wärmedämmplatte nach Anspruch 3, wobei Y eines oder mehrere von einer Glycidoxypropyl-Gruppe, einer 3,4-Epoxycyclohexylethyl-Gruppe, einer Styryl-Gruppe, einer Acrylat-Gruppe, einer Methylmethacrylat-Gruppe, einer Vinyl-Gruppe und einem Derivat davon, einer Thiolpropyl-Gruppe und einer Aminopropypl-Gruppe ist.

**6.** Wärmedämmplatte nach Anspruch 3, wobei R eines von einer Methylgruppe, einer Ethylgruppe und einer Propylgruppe ist.

**7.** Verfahren zur Herstellung einer Wärmedämmplatte, das Folgendes umfasst:

Bereitstellen einer wässrigen Silicat-Lösung mit hohem Molverhältnis, die eine Partikelgröße von 1 bis 10 nm aufweist, die eine mittlere Größe zwischen Wasserglas und kolloidalem Silica ist, als ein Material und Beimengen einer Säure zu der wässrigen Silica-Lösung mit hohem Molverhältnis, um ein Sol zuzubereiten; oder
Bereitstellen eines Wasserglases als ein Material, Beseitigen von Natrium von dem Wasserglas durch Ionenaustausch und dann Beimengen einer Base dazu, um eine Sol-Lösung zuzubereiten;
Imprägnieren eines Vliesstoffs mit der Sol-Lösung;
Durchführen einer Polymerisationsreaktion auf Basis von Dehydratisierungskondensation bei 50 °C bis 100 °C, um ein Hydrogel zu erhalten;
Hydrophobierung einer Fläche des Hydrogels mit einem Silan-Haftvermittler, der eine reaktive organische funktionelle Gruppe aufweist, wobei der Silan-Haftvermittler durch $Y_nSi(OR)_{4-n}$ dargestellt ist;
Trocknen des hydrophobierten Hydrogels; und
Erhitzen des getrockneten Hydrogels auf 100 °C oder höher, um zu bewirken, dass Y, die die reaktive organische funktionelle Gruppe ist, eine ringöffnende Polymerisation durchläuft, wodurch es dem Silica-Trockengel und dem Stoff ermöglicht wird, sich aneinander zu binden, wobei,
in dem Silan-Haftvermittler, der durch $Y_nSi(OR)_{4-n}$ dargestellt ist, Y, die der reaktiven organischen funktionellen Gruppe entspricht, eines von einer Glycidoxypropyl-Gruppe, einer 3,4-Epoxycyclohexylethyl-Gruppe, einer Styryl-Gruppe, einer Acrylat-Gruppe, einer Methylmethacrylat-Gruppe, einer Vinyl-Gruppe und einem Derivat davon, einer Thiolpropyl-Gruppe und einer Aminopropypl-Gruppe ist,
R eines von einer Methylgruppe, einer Ethylgruppe und einer Propylgruppe ist, und
n 1 bis 3 ist.

**8.** Verfahren zur Herstellung einer Wärmedämmplatte nach Anspruch 7, wobei Y, das der reaktiven organischen funktionellen Gruppe entspricht, eine Glycidoxypropyl-Gruppe ist.

**9.** Verfahren zur Herstellung einer Wärmedämmplatte nach Anspruch 7, wobei eines von

3-Glycidoxypropylmethyldimethoxysilan,
3-Glycidoxypropylmethyldiethoxysilan, und
2-(3,4-Epoxycyclohexyl)ethyltrimethoxysilan

für $Y_nSi(OR)_{4-n}$ in dem Hydrophobierungsschritt verwendet wird.

**10.** Verfahren zur Herstellung einer Wärmedämmplatte nach Anspruch 7, wobei 3-Glycidoxypropyltrimethoxysilan für $Y_nSi(OR)_{4-n}$ in dem Hydrophobierungsschritt verwendet wird.

**Revendications**

**1.** Feuille d'isolation thermique comprenant :

un xérogel de silice (101) ; et
une étoffe non tissée (102), dans laquelle

le xérogel de silice et l'étoffe non tissée sont chimiquement réticulées l'un à l'autre par l'intermédiaire d'un agent de couplage de type silane (103) ayant un groupe fonctionnel organique réactif (104).

2. Feuille d'isolation thermique selon la revendication 1, dans laquelle une pluralité de particules de silice dudit xérogel de silice sont chimiquement réticulées les unes aux autres par l'intermédiaire de l'agent de couplage de type silane.

3. Feuille d'isolation thermique selon la revendication 1 ou 2, dans laquelle l'agent de couplage de type silane (103) est un composé alcoxysilane représenté par $Y_nSi(OR)_{4-n}$ ayant au moins un type du groupe fonctionnel réactif Y (104).

4. Feuille d'isolation thermique selon la revendication 3, dans laquelle l'un quelconque ou plusieurs parmi $R_3SiO(SiR_2O)_nSiR_3$, $R_3SiCl$, et $R^1_nSi(OR^2)_{4-n}$ sont en outre incorporés à titre d'agents de silylation.

5. Feuille d'isolation thermique selon la revendication 3, dans laquelle Y est l'un quelconque ou plusieurs parmi un groupe glycidoxypropyle, un groupe 3,4-époxycyclohexyléthyle, un groupe styryle, un groupe acrylate, un groupe méthacrylate de méthyle, un groupe vinyle et un dérivé de celui-ci, un groupe thiolpropyle, et un groupe aminopropyle.

6. Feuille d'isolation thermique selon la revendication 3, dans laquelle R est l'un quelconque parmi un groupe méthyle, un groupe éthyle et un groupe propyle.

7. Procédé pour produire une feuille d'isolation thermique, comprenant :

l'obtention, en tant que matériau, d'une solution aqueuse de silicate ayant un rapport molaire élevé présentant une granulométrie de 1 à 10 nm, qui est d'une taille moyenne entre le verre soluble et la silice colloïdale, et l'addition d'un acide à la solution aqueuse de silicate ayant un rapport molaire élevé pour préparer un sol ; ou l'obtention d'un verre soluble en tant que matériau, l'élimination du sodium dans le verre soluble par échange d'ions, et ensuite l'addition d'une base à celui-ci pour préparer une solution de sol ;
l'imprégnation d'une étoffe non tissée avec la solution de sol ;
la mise en oeuvre d'une réaction de polymérisation basée sur une condensation par déshydratation à une température de 50 °C à 100 °C pour que soit obtenu un hydrogel ;
la dotation d'un caractère hydrophobe à une surface de l'hydrogel avec un agent de couplage de type silane ayant un groupe fonctionnel organique réactif, l'agent de couplage de type silane représenté par $Y_nSi(OR)_{4-n}$ ;
le séchage de l'hydrogel rendu hydrophobe ; et
le chauffage de l'hydrogel séché à 100 °C ou plus pour faire en sorte que Y, qui est le groupe fonctionnel organique réactif, subisse une polymérisation par décyclisation, ce qui permet ainsi la liaison l'un à l'autre d'un xérogel de silice et de l'étoffe, dans lequel,
dans l'agent de couplage de type silane représenté par $Y_nSi(OR)_{4-n}$, Y, qui correspond au groupe fonctionnel organique réactif, est l'un quelconque parmi un groupe glycidoxypropyle, un groupe 3,4-époxycyclohexyléthyle, un groupe styryle, un groupe acrylate, un groupe méthacrylate de méthyle, un groupe vinyle et un dérivé de celui-ci, un groupe thiolpropyle, et un groupe aminopropyle,
R est l'un quelconque parmi un groupe méthyle, un groupe éthyle et un groupe propyle, et
n vaut de 1 à 3.

8. Procédé pour produire une feuille d'isolation thermique selon la revendication 7, dans lequel Y, qui correspond au groupe fonctionnel organique réactif, est un groupe glycidoxypropyle.

9. Procédé pour produire une feuille d'isolation thermique selon la revendication 7, dans lequel l'un quelconque parmi

le 3-glycidoxypropylméthyldiméthoxysilane,
le 3-glycidoxypropylméthyldiéthoxysilane, et
le 2-(3,4-époxycyclohexyl)éthyltriméthoxysilane

est utilisé pour $Y_nSi(OR)_{4-n}$ dans l'étape de dotation d'un caractère hydrophobe.

10. Procédé pour produire une feuille d'isolation thermique selon la revendication 7, dans lequel du 3-glycidoxypropyltriméthoxysilane est utilisé pour $Y_nSi(OR)_{4-n}$ dans l'étape de dotation d'un caractère hydrophobe.

## FIG. 1

# FIG. 2

| | |
|---|---|
| (1) SOL PREPARATION STEP | SILICA MATERIAL → ← CATALYST → SOL SOLUTION |
| (2) IMPREGNATION STEP | ← UNWOVEN FABRIC → IMPREGNATION |
| (3) GELATION STEP | GELATION |
| (4) CURING STEP | CURING |
| (5) ACID IMMERSION STEP (COUPLING STEP) | ACID → COUPLING |
| (6) DRYING STEP | DRYING |
| (7) CROSS-LINKING STEP | CROSS-LINKING → HEAT INSULATION SHEET |

# FIG. 3

101

Silanol on the surface
of the hydrogel

103

104

3-glycidoxypropyl
trimethoxysilane

Si(OCH₃)₃

104

## FIG. 4

## FIG. 5

## FIG. 6

## REFERENCES CITED IN THE DESCRIPTION

**Patent documents cited in the description**

- JP 2009073731 A
- JP 10504793 T

**Non-patent literature cited in the description**

- **S. S. KISTER.** *Nature,* 1931, vol. 127, 741